# EUROPÄISCHE PATENTSCHRIFT

(11) **EP 0 267 249 B1**
(45) Veröffentlichungstag und Bekanntmachung des Hinweises auf die Patenterteilung: **04.08.1993**
(21) Anmeldenummer: 87903304.1
(22) Anmeldetag: 15.05.1987
(51) Int. Cl.: B23K 20/00, B23K 20/10

(54) **VORRICHTUNG ZUM MANUELLEN DRAHTBONDEN**
DEVICE FOR MANUAL WIRE BONDING
DISPOSITIF POUR LA CONNEXION MANUELLE DE CONDUCTEURS

(30) Priorität: 16.05.1986 DE 3616651
(43) Veröffentlichungstag der Anmeldung: 18.05.1988
(73) Patentinhaber: F & K Delvotec Bondtechnik GmbH, D-82041 Oberhaching (DE)
(72) Erfinder: Farassat, Farhad, D-8000 München 71 (DE)
(74) Vertreter: Popp, Eugen, Dr.
(86) Internationale Anmeldenummer: EP8700258
(87) Internationale Veröffentlichungsnummer: WO8706864

(56) Entgegenhaltungen:
- WO-A-83/04201
- GB-A- 2 047 596

## Beschreibung

Die Erfindung betrifft eine Vorrichtung zum Drahtbonden gemäß Oberbegriff des Patentanspruches 1.

Aus der US-A-4 266 710 ist eine Vorrichtung zum Drahtbonden mit einem ultraschallerregbaren und/oder Thermokompressions-Stempel zum Anpressen des Drahtes an eine Kontaktfläche bekannt. Dabei ist der Stempel Teil eines auf die Kontaktfläche zu und von dieser wieder wegbewegbaren Bondkopfes. Die Kontaktfläche ist auf einer sich in Richtung etwa quer zur Bewegungsrichtung des Bondkopfes unter Positionierung der Kontaktfläche gegenüber dem Stempel bewegbaren Unterlage angeordnet. Weiterhin umfaßt diese bekannte Vorrichtung einen Antrieb für den Bondkopf, dem eine Wegstrecken- und Geschwindigkeits-Steuereinheit sowie eine Wegstrecken- und Geschwindigkeits-Rückmeldeeinheit zugeordnet sind. Der Bondkopf läßt sich nach folgendem Zyklus bewegen: Zunächst wird der Bondkopf aus einer angehobenen Startposition auf eine erste Bereitstellungsposition abgesenkt. Sodann wird der Bondkopf mit veringerter Geschwindigkeit weiter auf die erste Kontaktfläche abgesenkt, und zwar unter Anpressung des zu bondenden Drahtes an dieser Kontaktfläche. Hiernach wird der Bondkopf von der ersten Kontaktfläche unter Bewegung desselben in eine vorgegebene Loop-Position abgehoben. Anschließend wird der Bondkopf auf eine Zweite Bereitstellungsposition abgesenkt. Danach erfolt ein mit erneut verringert Geschwindigkeit weiteres Absenken des Bondkopfes auf die zweite Kontaktfläche, wiederum unter Anspressung des zu bondenden Drahtes an dieser Kontaktfläche. Nach vorangehender Abtrennung des gebondeten Drahtabschnittes wird der Bondkopf schließlich zurück in die Startpostion angehoben.

Bei dieser bekannten Vorrichtung zum Drahtbonden handelt es sich um einen ausschließlich vollautomatisch arbeitenden Bonder. Insofern ist kein individueller Eingriff in den Betriebsablauf dieses Bonders möglich, und zwar während des eigentlichen Bondvorganges. Insbesondere ist bei diesem Bonder nicht vorgesehen, den Bondkopf in einer ersten und einer zweiten Bereitstellungspostion verharren zu lassen und demzufolge eine solche Verharrung über die vorhandene Tastatur bzw. dem damit verbundenen Prozessor einzugeben. Aufgrund der hieraus resultierenden aufwendigen Handhabung ist dieser bekannte Bonder für den Einsatz in sogenannten Dritt- bzw. Schwellenländern nicht geeignet. Darüber hinaus lassen sich mit diesem bekannten Bonder nicht ohne Schwierigkeit Bondversuche sowie Pull-Tests durchführen. Schließlich ist dieser bekannte Bonder auch für die Fertigung von Kleinserien oder Einzelstücken von Halbleiterbauelementen ungeeignet.

Weiterhin ist in der GB-A 2 047 596 ein Verfahren zum vollautomatischen Drahtbonden von Halbleiter-Bauelementen vorgestellt, mittels welchem die Anschlüsse eines auf einem Trägersubstrat angeordneten Halbleiter-Bauelementes mit den entsprechenden Anschlüssen des Trägersubstrates verbunden werden sollen. Zu diesem Zweck wird ein von einem Motor angetriebener Stempel nach einem ganz bestimmten, starren Bewegungsablauf, d.h. beispielsweise ohne jegliche Veränderung der Bewegungsgeschwindigkeiten oder Verharrungszeiten, betätigt. Sobald das entsprechende Halbleiter-Bauelement in der Maschine eingespannt ist, kann das Drahtbonden zwischen dem Halbleiter-Bauelement einerseits und dem Trägersubstrat andererseits daher nurmehr nach einem starren Bewegungsablauf des Stempels erfolgen. Ein variables Einstellen der Bewegungsgeschwindigkeiten, Bewegungsstrecken und Verharrungszeiten während des Bewegungsablaufes des Stempels ist insofern nicht erreichbar. Auf mögliche Fehler während des Bewegungsablaufes des Stempels läßt sich zudem nicht direkt und umgehend Einfluß nehmen. Festgestellte Fehler müssen vielmehr erst nach Beendigung des letzten Bewegungsablaufes des Stempels in einem zusätzlichen Arbeitsgang von Hand behoben werden. Die zu diesem bekannten Verfahren gehörige Vorrichtung zum vollautomatischen Drahtbonden ist darüber hinaus für einen Einsatz in sogenannten Schwellenländern aufgrund deren viel zu umständlichen und aufwendigen Handhabung und nicht zuletzt infolge der erforderlichen, hochkomplizierten Hard- bzw. Software ungeeignet.

Ausgehend vom Stand der Technik liegt der Erfindung die Aufgabe zugrunde, eine Vorrichtung zum Drahtbonden der gattungsgemäßen Art bereitzustellen, die bei vergleichsweise geringem Konstruktionsaufwand außerordentlich leicht handhabbar ist und zudem präzise arbeitet sowie an unterschiedlichste äußere Bedingungen anpaßbar ist.

Die Aufgabe wird erfindungsgemäß durch die kennzeichnenden Merkmale des Patentanspruches 1 gelöst.

Demnach wird bei der erfindungsgemäßen Vorrichtung zum Drahtbonden eine Verharrung des Bondkopfes in einer ersten und einer zweiten Bereitstellungsposition durch entsprechende Betätigung bzw. Loslassen eines Startknopfes bestimmt. Der Benutzer hat auf diese Weise ausreichend Zeit, die Bondstelle unter dem Bondkopf zu positionieren. Auf diese Weise läßt sich zusammen mit den Wegstrecken- und Geschwindigkeits- Potentiometern gemäß der Vorrichtung nach der Erfindung jede Teilbewegung und Verharrung des Bondkopfes während eines beliebigen Bewegungsablaufes hinsichtlich Bewegungsstrecke, Bewegungsgeschwindigkeit und Verharrungszeit individuell einstellen. Hierdurch kann mittels erfindungsgemäßer Vorrichtung ein manuelles Drahtbonden von Halbleiter-Bauelement einerseits und Trägersubstrat andererseits stattfinden. Durch den erfindungsgemäßen Speicher ist des weiteren eine hohe Flexibilität der erfindungsgemäßen Vorrichtung zum Drahtbonden sichergestellt, d.h. die Anpassung an unterschiedlich hoch gebaute Bauelemente bzw. Kontaktstellen. Schließlich ist erfindungsgemäß eine Wegstrecken-Geschwindigkeits-Rückmeldeeinheit vorgesehen, mittels welcher sich jede Teilbewegung und Verharrung des Bondkopfes während seines Bewegungsablaufes hinsichtlich dessen Bewegungsstrecke, Bewegungsgeschwindigkeit und Verharrungszeit entsprechend der individuellen Voreinstellung überprüfen lassen. Die Reset-Einrichtung erlaubt in diesem Zusammenhang einen manuellen Eingriff in den Bewegungsablauf des Bondkopfes, sobald Fehler festgestellt werden.

Die Vorrichtung zum Drahtbonden nach der Erfindung zeichnet sich infolge dessen durch eine außerordentlich einfache Handhabung aus, mittels welcher der Bewegungsablauf des Bondkopfes ohne weiteres an äußere Gegebenheiten manuell, direkt und umgehend angepaßt werden kann. Infolge dieser einfachen Handhabung eignet sich die erfindungsgemäße Vorrichtung besonders gut zum Einsatz in sogenannten Dritt- bzw. Schwellenländern. Darüber hinaus lassen sich mit der erfindungsgemäßen Vorrichtung Bondversuche ebenso wie Pull-Tests ohne Schwierigkeit durchführen. Auf einfache Weise können mit der erfindungsgemäßen Vorrichtung auch Betriebsbedingungen, wie sie beim automatisierten Drahtbonden auftreten, experimentell festgestellt werden. Weiterhin kann durch die erfindungsgemäße Vorrichtung genau überprüft werden, ob der Bondkopf sämtliche für dessen Bewegungsablauf voreingestellte Parameter ausführt. Bei nicht funktionsgemäßer Ausführung kann der Bondvorgang unterbrochen, die entsprechende Fehlerquelle überprüft, beseitigt und anschließend der Bewegungsablauf manuell von neuem gestartet werden. Die Ausschußquote beim Drahtbonden von beispielsweise Halbleiter-Bauelementen mit entsprechenden Trägersubstraten läßt sich auf diese Weise ganz erheblich reduzieren.

Von großer Bedeutung bei der Vorrichtung zum Drahtbonden nach der Erfindung ist neben der individuellen Einstellbarkeit auch deren Überprüfbarkeit jeder einzelnen Funktion. Somit ist die Gegenkontrolle der ausgeführten Bewegungen des Bondkopfes sowie der diesem zugeordneten bewegten Aggregate, wie z.B. die Drahtklemme oder der Schwingungsdämpfer, von Wichtigkeit. Für die Bewegung des Bondkopfes und der Steuerung eignet sich in besonderem Maße ein Gleichstrom-Servomotor, und zwar wegen seiner Charakteristik, wobei grundsätzlich auch andere Antriebe, beispielsweise Schrittmotoren verwendbar sind.

Vorteilhafte Ausgestaltungen der Vorrichtung zum Drahtbonden nach der Erfindung sind in den Unteransprüchen beschrieben.

Nachstehend wird eine bevorzugte Ausführungsform einer erfindungsgemäß ausgebildeten Vorrichtung anhand der beigefügten Zeichnung näher beschrieben. Es zeigen:
- Fig. 1: den Bondkopf einer erfindungsgemäß ausgebildeten Bond-Vorrichtung in Seitenansicht;
- Fig. 2: den Bondkopf nach Fig. 1 in Vorderansicht;
- Fig. 3: die Schalttafel der erfindungsgemäß ausgebildeten Vorrichtung in schematischer Draufsicht;
- Fig. 4: schematische Darstellung der Geschwindigkeitssteuerung und -rückmeldung des Antriebes für den Bondkopf; und
- Fig. 5a-5c: Funktionsdarstellung (flow chart) der erfindungsgemäßen Vorrichtung.

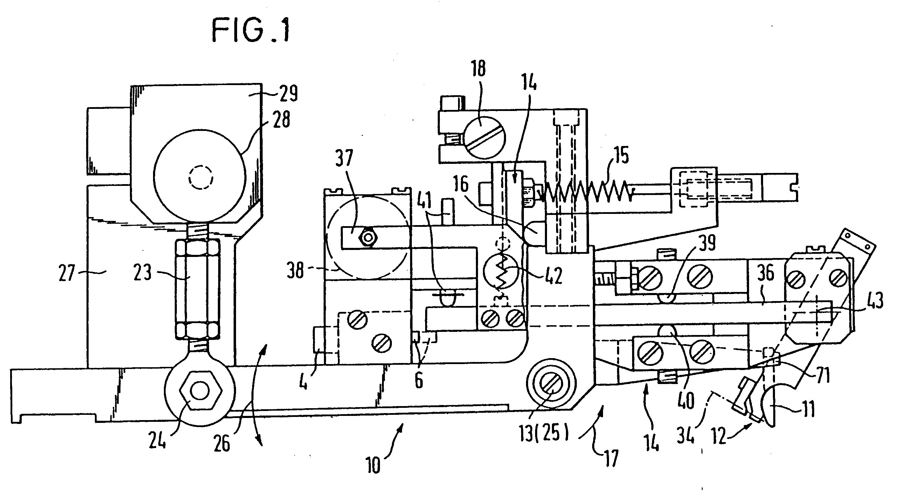

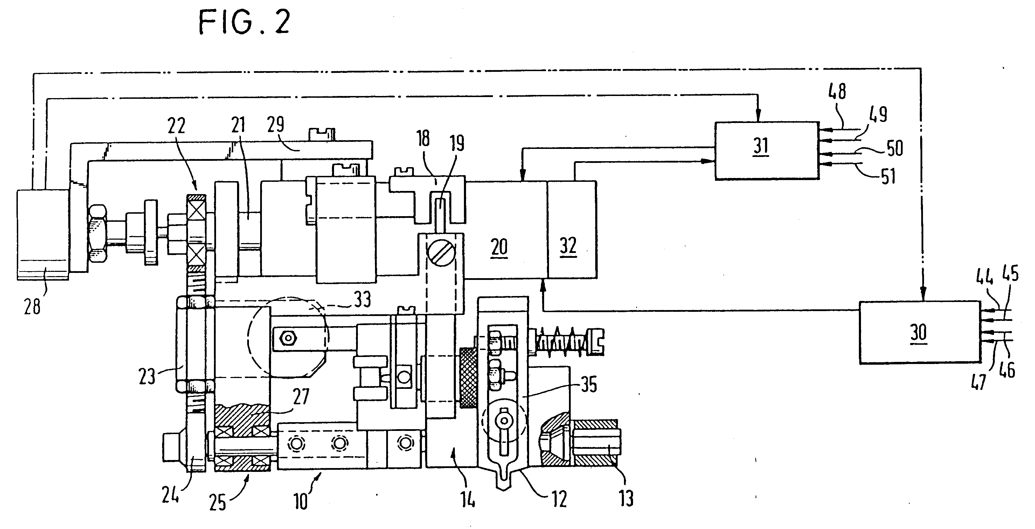

In den Fig. 1 und 2 ist lediglich ein bevorzugt ausgebildeter Bondkopf einer Vorrichtung zum manuellen Drahtbonden dargestellt. Dieser Bondkopf ist an einem nicht gezeigten Standrahmen befestigt. Unterhalb des Bondkopfes befindet sich eine Unterlage für die zu bondenden Bauelemente etc.. Auch diese ist nicht dargestellt, da es sich dabei um ein dem Prinzip nach bekanntes Bauteil handelt. Es sei nur an dieser Stelle vermerkt, daß die Unterlage sich in Richtung etwa quer zur Bewegungsrichtung 10 unter Positionierung der zu bondenden Kontaktflächen bewegen läßt. Der Bondkopf 10 umfaßt einen mit einer Ultraschallquelle wirkverbundenen Stempel (wedge) 11, dem eine Drahtklemme 12 zugeordnet ist. Die Drahtklemme 12 ist relativ zum Stempel 11 in Drahtlängsrichtung bzw. Drahtzuführungsrichtung hin- und herbewegbar gelagert. Desweiteren ist sie in Schließstellung vorgespannt, so daß sie entgegen dieser Vorspannung geöffnet werden muß, um relativ zum Draht ohne Mitnahme desselben bewegt werden zu können.

Der Stempel 11 ist an einer im Bondkopf 10 um eine Achse 13 schwenkbar gelagerte Halterung 14 befestigt. Die Halterung 14 wird durch eine Zugfeder 15 in Anlage an einen Anschlag 16 gehalten. Entgegen der Wirkung der Zugfeder 15 ist die Halterung 14 und damit der Stempel 11 um die Schwenkachse 13 entgegen der Uhrzeigerrichtung (Pfeil 17) schwenkbar bzw. nach oben auslenkbar. Diese Auslenkung bzw. Schwenkbewegung erfolgt bei sogenannten "touch down" des Stempels 11, d.h. beim Aufsetzen des Stempels 11 auf die zu bondende Kontaktfläche. Die Auslenkung der Halterung 14 und damit der "touch down" des Stempels 11 wird durch einen im Bondkopf 10 angeordneten Sensor in Form einer Lichtschranke 18 festgestellt. Konkret kommt in der dargestellten Ausführungsform eine Gabellichtschranke zur Anwendung, in die ein vorspringender Teil 19 der Halterung 14 hineinragt (siehe Fig. 2). Die Lichtschranke 18 kann relativ zum Vorsprung 19 so eingestellt werden, daß der "touch down" erst dann angezeigt wird, wenn die Halterung 14 um die Achse 13 in Richtung des Pfeiles 17 um einen vorbestimmten Winkel aus der Null- bzw. Stellung in Anlage am Anschlag 16 verschwenkt ist. Dieser Winkel definiert den sogenannten "over drive". Damit ist gewährleistet, daß der Stempel 11 mit vorgegebener Kraft - bestimmt durch die Zugfeder 15 - gegen die Kontaktfläche drückt. Gleichzeitig wird durch die Lichtschranke 18 dann ein Signal für den Antrieb zur Auf- und Abbewegung des Bondkopfes 10 - die weiter unten noch näher beschrieben wird - erzeugt dahingehend, daß der Antrieb abgeschaltet wird und der Bondkopf 10 stoppt. Der Bondkopf 10 nimmt dann die sogenannten "touch down"-Höhe ein. Diese wird zur Bestimmung der Loop-Höhe zwischengespeichert.

Die Auf- und Abbewegung des Bondkopfes 10 erfolgt mittels eines DC-Servomotors 20 (siehe Fig. 2). Der Servomotor 20 ist im nicht dargestellten Standrahmen der Vorrichtung ortsfest gelagert. Die Abtriebswelle 21 des Motors 20 ist mit einem Exzenter 22 gekoppelt. Dieser wiederum ist mit einem sich etwa vertikal erstreckenden und längenveränderbaren Stößel 23 verbunden, dessen anderes, hier unteres, Ende am Bondkopf 10 angelenkt ist (Anlenkung 24). In Vertikalrichtung kann der Bondkopf 10 durch in Linearlager geführt sein. Bei der dargestellten Ausführungsform ist der Bondkopf 10 um ein im Standrahmen angeordnetes Schwenklager 25 verschwenkbar. Die Schwenkachse dieses Lagers fluchtet mit der bereits erwähnten Schwenkachse 13 für die Halterung 14 des Stempels 11. Die Schwenkbewegung des Kopfes 10 um das Lager 25 ist in Fig. 1 durch den Doppelpfeil 26 dargestellt. In Fig. 2 ist im übrigen ein Teil des Standrahmens gezeigt, und zwar der das Schwenklager 25 umfassende Teil. Dieser Teil ist mit der Bezugsziffer 27 gekennzeichnet.

Die Abtriebswelle 21 des DC-Servomotores 20 ist durch den Exzenter 22 hindurch mechanisch mit einem feed-back Potentiometer 28 gekoppelt, der an einem rahmenfesten Haltebügel 29 befestigt ist. Dies feed back Potentiometer ist zum einen mit einer Wegstrecken-Vergleichseinheit und zum anderen mit einer Geschwindigkeits-Wähleinrichtung 31 gekoppelt, deren Funktion weiter unten noch näher beschrieben wird.

Dem Servomotor ist desweiteren ein Tachogenerator 32 zugeordnet, der Geschwindigkeits-Ist-Signale an die Geschwindigkeits-Wähleinrichtung 31 liefert.

Um durch die Auf- und Abbewegung des Bondkopfs 10 bedingte Schwingungen am Stempel 11 vor dem eigentlichen Bondvorgang zu unterdrücken bzw. zu dämpfen, ist der Halterung 14 für den Stempel 11 ein Dämpf-Solenoid 33 zugeordnet, der wahlweise erregbar ist und dann die Halterung 14 gegen den Anschlag 16 drückt. Beim "touch down" des Bondkopfes bzw. der "touch down"-Bewegung desselben muß der Dämpf-Solenoid selbstverständlich wieder abgeregt werden, so daß die Halterung 14 um die Schwenkachse 13 wieder frei verschwenkbar ist.

Die Drahtführung zum Stempel bzw. wedge 11 durch die Drahtklemme 12 hindurch ist in Fig. 1 durch die Linie 34 angedeutet. Die Drahtklemme 12 ist ein in Schließstellung vorgespannter U-Bügel 35 (siehe Fig. 2). Der eine Schenkel des U-Bügels 35 ist mit einem im Bondkopf 10 um eine vertikale Achse schwenkbar gelagerten Hebel 36 verbunden, auf dessen diametrales Ende 37 ein Solenoid bzw. Elektromagnet 38 wird derart, daß bei Erregung des Solenoids 38 der Hebel 36 unter Öffnung der Drahtklammer 12 verschwenkt wird. Der Hebel 36 bewegt sich dabei mit seinem, mit der Drahtklemme 12 gekoppelten, Ende in Fig. 1 aus der Papierbene nach oben heraus.

Schließlich ist der Hebel 36 im Bodnkopf 10 noch um eine horizontale, sich etwa parallel zur Schwenkachse 13 erstreckende Achse schwenkbar gelagert, wobei die Schwenkbewegung nach oben durch einen Anschlag 39 und nach unten durch einen Anschlag 40 begrenzt ist. Die Schwenkbewegung des Hebels 36 und damit der Drahtklemme 12 in vertikaler Ebene erfolgt durch einen Solenoid bzw. Elektromagneten 41, und zwar entgegen der Wirkung einer Zugfeder 42, der sogenannten Abreißfeder. Der obere Anschlag 39 definiert die sogenannte Null-Position der Drahtklemme 12. Mit dem unteren Anschlag 40 kann der Draht-Nachschub bzw. die sogenannte "tail-length" eingestellt werden. Die Anschläge 39 und 40 sind jeweils lageveränderbar in der Halterung 14 für den Stempel 11 angeordnet. Der Hebel 36 ist ebenso wie der Solenoid 38, Solenoid 41 und die Anschläge 39, 40 sowie die Abreißfeder 42 Teil der schwenkbar gelagerten Halterung 14. Die horizontale Schwenkachse des Hebels 36 wird durch die Schwenkachse 43 der Drahtklemme 12 am vorderen bzw. frei zugänglichen Ende der Halterung 14 definiert. Diese Schwenkachse 43 erstreckt sich etwa parallel zur Schwenkachse 13 der Halterung 14 innerhalb des Bondkopfes 10.

Dem Hebel 36 ist desweiteren ein Solenoid 4 zugeordnet, dessen Anker mit einem vorstehenden Stößel 6 verbunden ist. Der Stößel 6 ist durch Erregung des Solenoids 4 in eine solche Lage bringbar, daß die Bewegung des Hebels 36 um die Schwenkachse 43 in Fig. 1 nach unten begrenzt wird. Die entsprechende Stellung des Stößels 46 ist in Fig. 1 gestrichelt dargestellt. Die Begrenzung der Schwenkbewegung des Hebels 36 und damit der Drahtklemme 12 wird immer dann wirksam, wenn die Drahtklemme 12 in Draht-Abreißstellung gebracht werden soll. Die Drahtklemme 12 wird dabei in geöffneter Stellung relativ zum Draht 34 ohne Mitnahme desselben in Fig. 1 nach rechts bewegt (die Drahtklemme 12 dreht um die Achse 43 entgegen der Uhrzeigerrichtung). Diese Relativbewegung der Drahtklemme 12 wird durch den ausgefahrenen Stößel 6 (in Fig. 1 gestrichelt dargestellt) begrenzt. Soll nun der Draht 34 nach Befestigung an der Kontaktfläche bei noch anliegendem Stempel 11 abgerissen werden, wird der Solenoid 41 lediglich entregt mit der Folge, daß der Hebel 36 durch die Abreißfeder 42 schlagartig in Fig. 1 nach oben gezogen wird unter gleichzeitiger Verschwenkung der Drahtklemme 12 um die Achse 43 in Uhrzeigerrichtung. Vorher wird die Drahtklemme 12 jedoch noch in Schließstellung gebracht.

Nachstehend soll nun die Funktion des erfindungsgemäß ausgebildeten Bondgerätes beschrieben werden:
Der Wegstrecken-Vergleichseinheit 30, die sowohl mit dem Antrieb 20 als auch mit dem feed-back Potentiometer 28 in Funktionsverbindung steht, sind vier Wegstrecken-Potentiometer 44, 45, 46 und 47 zugeordnet, mit denen folgende Vorgaben erteilt werden:
- Potentiometer 44: Festlegung der Startposition bzw. -höhe des Bondkopfes 10 über der die Kontaktfläche tragenden Unterlage;
- Potentiometer 45: Festlegung der ersten Bereitstellungsposition bzw. -höhe (search-Höhe H1 ) des Bondkopfes 10;
- Potentiometer 46: Festlegung der zweiten Bereitstellungsposition bzw. -höhe (search-Höhe H2) des Bondkopfes 10;
- Potentiometer 47: Festlegung der loop-Höhe.

Der Geschwindigkeits-Wähleinrichtung 31 sind ebenfalls vier Potentiometer, nämlich Geschwindigkeits-Potentiometer 48, 49, 50 und 51 zugeordnet. Mit dem Potentiometer 48 wird die Bewegung des Bondkopfes 10 in die Startposition, die durch das Potentiometer 44 festgelegt ist, ausgelöst, wobei mit dem Potentiometer 48 gleichzeitig die Bewegungsgeschwindigkeit festgelegt wird.

Mit dem Potentiometer 49 wird die touch-down-Geschwindigkeit bestimmt. Das Potentiometer 50 dient zur Festlegung der "up and down"-Geschwindigkeit des Bondkopfes 10, die Höhe ist als die "touch down"-Geschwindigkeit definiert.

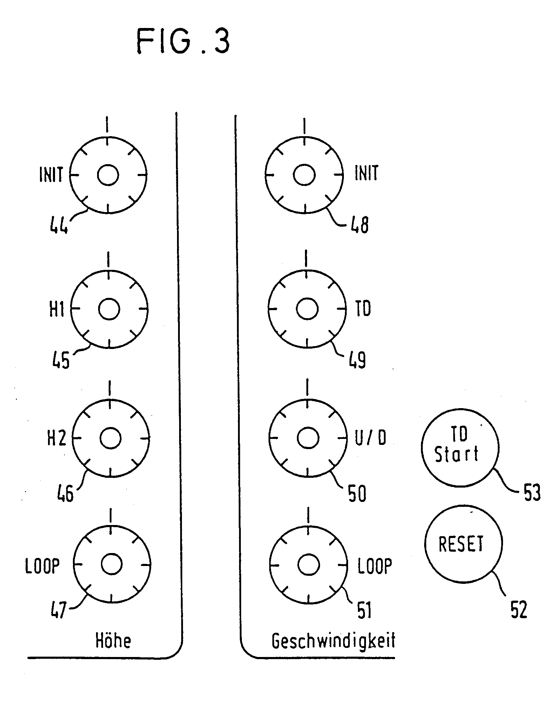

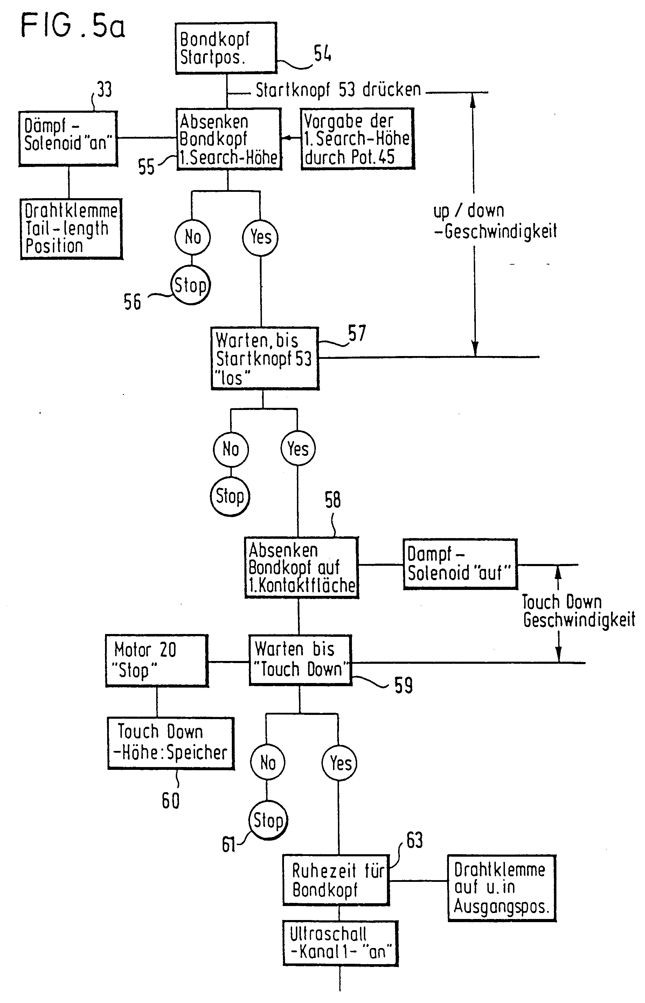

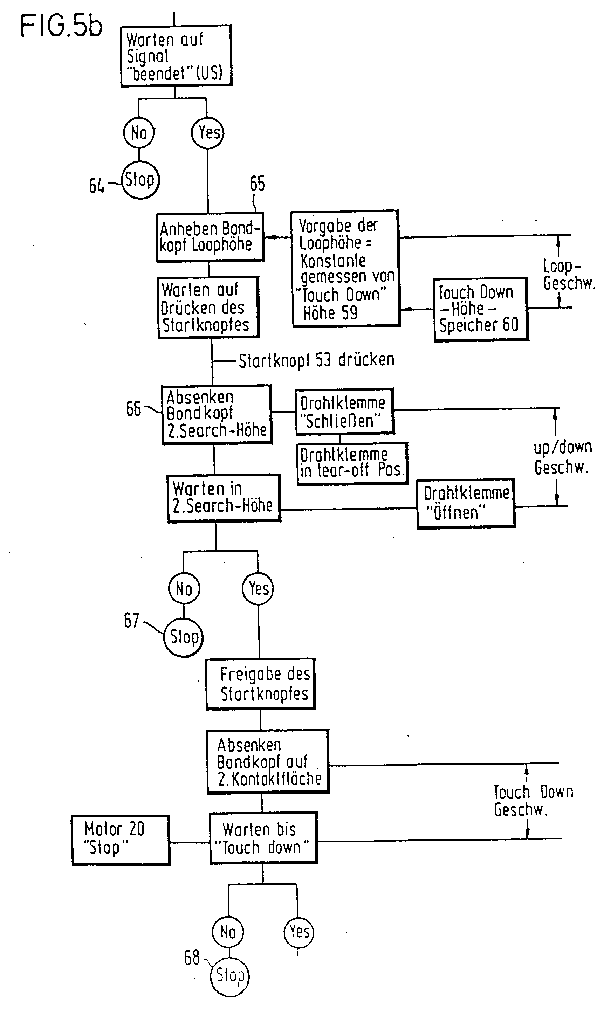

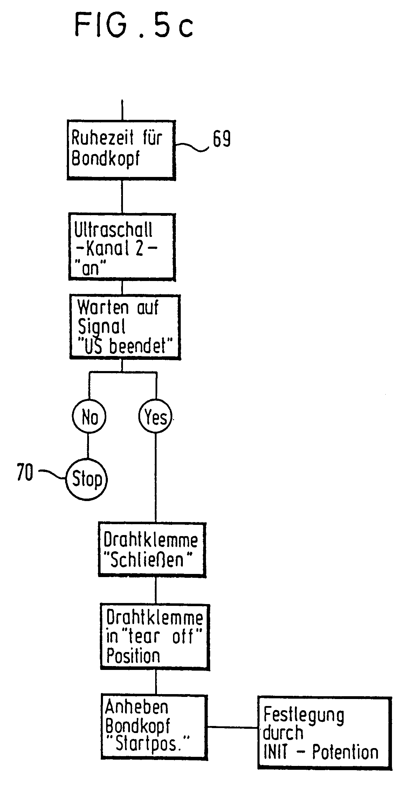

Mit dem Potentiometer 51 wird schließlich die sogenannte "loop"-Geschwindigkeit des Bondkopfes 10 eingestellt. Die Potentiometer sind an einem Schaltpult gemäß Fig. 3 angeordnet. Dieses Schaltpult enthält desweiteren einen reset-Schalter 52 sowie einen Startknopf 53. Durch Drücken des Startknopfes 53 soll sich der Bondkopf 10 von der Startposition 54 auf die erste Bereitstellungshöhe (erste search-Höhe) 55 absenken. Die erste Bereitstellungshöhe des Bondkopfes 10 wird durch das Potentiometer 45 vorgegeben. Die tatsächliche Absenkung des Bondkopfes wird festgestellt durch das feed-back-Pontentiometer 28. Dieses Ist-Signal wird in der Wegstrecken-Vergleichseinheit 30 mit dem durch das Potentiometer 45 vorgegebenen Sollwert verglichen. Entspricht die Isthöhe nicht der vorgegebenen Sollhöhe, wird der Bond-Vorgang abgebrochen (in Fig. 5a Stop 56). Der Bond-Vorgang kann dann durch Betätigung des reset-Schalters 52 von neuem gestartet werden, beginnend mit der Startposition 54. Stimmt der Istwert jedoch mit dem Sollwert überein, wartet der Bondkopf in der ersten Bereitstellungshöhe so lange, so lange der Startknopf 53 gedrückt ist (Wartestellung 57 in Fig. 5a). Während dieser Zeit wird manuell die erste zu bondende Kontaktfläche (nicht dargestellt) auf der in X- und Y-Richtung bewegbaren Unterlage gegenüber dem Stempel bzw. wedge 11 positioniert. Nach Positionierung der ersten Kontaktfläche wird der Startknopf 53 losgelassen mit der Folge, daß sich der Bondkopf weiter absenkt bis zur Anlage an die erste Kontaktfläche, und zwar mit verminderter Geschwindigkeit, nämlich der sogenannten "touch down"-Geschwindigkeit. Diese "touch down"-Geschwindigkeit wird durch das Potentiometer 49 eingestellt. Die "touch down"-Bewegung des Bondkopfes 10 ist in Fig. 5a mit dem Bezugszeichen 58 gekennzeichnet. Bei Beginn der "touch down"-Bewegung wird der beim Absenken des Bondkopfes 10 auf die erste Bereitstellungshöhe 55 geschaltete Dämpf-Solenoid 33 entregt, so daß der Stempel 11 samt Halterung 14 beim "touch down" bzw. beim Auftreffen auf die erste Kontaktfläche um die Achse 13 in Fig. 1 entgegen der Uhrzeigerrichtung schwenken kann, bis durch die Gabel-Lichtschranke 18 der "touch down" 59 festgestellt ist mit der Folge, daß dann der Motor 20 abgeschaltet wird. Der Stempel 11 wird in der "touch down"-Stellung gegen die Kontaktfläche gedrückt mit einer Kraft, die durch die Zugfeder 15 bestimmt ist. Die "touch down"-Stellung des Bondkopfes 10 wird ferner in einem Speicher zwischengespeichert. Über das feed-back-Potentiometer 28 wird gegengeprüft, ob der Bondkopf 10 nach dem "touch down"-Signal durch die Gabellichtschranke 18 tatsächlich angehalten hat. Sollte dies nicht der Fall sein, erfolgt ein Stop 61 des Bondvorganges mit der Folge, daß der Bondvorgang wiederholt werden muß durch Drücken des reset-Schalters 52. Der Bondkopf 10 würde dann wieder in die Startposition 54 verfahren werden. Zeigt jedoch das feed-back-Potentiometer 28 an, daß die Vertikalbewegung des Bondkopfes 10 mit dem "touch down"-Signal übereinstimmt, erhält der Antrieb 20 von einer Programmeinheit 62 den Befehl, in der "touch down"-Stellung zu verharren, z.B. für 40 ms. Dadurch wird erreicht, daß der Stempel 11 beim Bonden keine durch die "touch down"-Bewegung bedingte Schwingungen mehr ausführt, d.h. sich absolut ruhig verhält. Die Ruhezeit des Bondkopfes beim "touch down" ist in Fig. 5a mit der Bezugsziffer 63 gekennzeichnet. Nach Ablauf dieser Ruhezeit erhält der dem Stempel 11 zugeordnete transducer von der Programmeinheit 62 den Befehl, Ultraschall-Schwingungen auszuführen, und zwar auf einen ersten Kanal. Diese Ultraschall-Schwingungen sind nach Zeit und Leistung eingestellt (vorzugsweise manuelle Justierung).

Dieser Vorgang wird durch ein "Ende"-Signal abgebrochen. Wird durch die Programmeinheit ein solches "Ende"-Signal nicht festgestellt, wird der Bondvorgang abgebrochen (Stop 64 in Fig. 5b). Nach Anzeige des Ultraschall-Ende-Signales wird der Bondkopf 10 auf die sogenannte loop-Höhe 65 angehoben, die durch das loop-Potentiometer 47 eingestellt worden ist. Die loop-Höhe 65 ist eine konstante Vorgabe ausgehend von der zwischengespeicherten (Speicher 60) "touch down"-Höhe 59.Der Bondkopf 10 wird dabei mit loop-Geschwindigkeit angehoben. Über das feed-back-Potentiometer 28 könnte wieder abgefragt werden, ob der Bondkopf 10 tatsächlich die vorgegebene Wegstrecke ausgehend von der zwischengespeicherten "touch down"-Höhe zurückgelegt hat. Falls nein, könnte der Bondvorgang wieder unterbrochen und über den reset-Schalter 52 erneut begonnen werden.

Nachdem sich der Bondkopf 10 in der loop-Höhe 65 befindet, wird bei dem in den Fig. 5a bis 5c dargestellten Funktionsablauf (beispielhaft) erneut der Startknopf 53 gedrückt mit der Folge, daß der Bondkopf 10 sich auf die zweite Bereitstellungshöhe 66 (zweite search-Höhe) absenkt, in der der bondkopf schließlich verharrt. Die Absenkung erfolgt mit erhöhter "up and down"-Geschwindigkeit, die durch das Potentiometer 50 eingestellt ist. Mittels des feed-back-Potentiometers 28 und die Wegstrecken-Vergleichseinheit 30 wird wieder ein Soll/Ist-Vergleich durchgegeführt. Hat der Bondkopf 10 die durch das Potentiometer 46 vorgegebene zweite Bereitstellungshöhe nicht erreicht, erfolgt ein Stop-Signal 67 mit der Folge, daß der Bondvorgang erneut begonnen werden müßte durch Drücken des reset-Schalters 52. Stimmen Ist- und Sollwert überein und ist die zweite Kontaktfläche gegenüber dem Stempel bzw. wedge 11 positioniert, kann der Startknopf 53 wieder freigegeben werden mit der Folge, daß der Bondkopf 10 sich auf die zweite Kontaktfläche absenkt, und zwar wiederum mitverminderter "touch down"-Geschwindigkeit, bis der "touch down" auf der zweiten Kontaktfläche durch die Gabel-Lichtschranke 18 wieder festgestellt wird. Der Motor 20 wird nach Erhalt dieses Signales gestoppt. Stimmt die tatsächliche Bewegung des Bondkopfes 10 mit dem "touch down"-Signal nicht überein, wird der Bondvorgang unterbrochen (Stop 68 in Fig. 5b mit der bereits oben beschriebenen Folge). Im übrigen erhält der Antrieb 20 durch die Programmeinheit 62 wieder ein Ruhe- bzw. Verharrungssignal 69 von z.B. 40 ms, um den auf der Kontaktfläche aufliegenden wedge 11 absolut ruhig zu stellen. Nach Beruhigung des Bondkopfes 10 bzw. wedge 11 wird an den transducer der Befehl erteilt, Ultraschall-Schwingungen auszuführen, und zwar auf Kanal 2. Dies bedeutet, daß Zeit und Intensität unterschiedlich gewählt sein können im Vergleich zur Ultraschall-Schwingung auf Kanal 1. Der Befehl an den transducer erfolgt durch die Programmeinheit 62. Die Ultraschall-Schwingung wird durch ein Ultraschall-Ende-Signal ausgelöst. Erfolgt dieses nach vorgegebener Zeit nicht, wird der Bondvorgang unterbrochen (Stop 70 in Fig. 5c). Nach dem Ultraschall-Ende-Signal erhält der für das Öffnen der Drahtklemme 12 verantwortliche Solenoid 38 den Befehl, die Drahtklemme 12 zu schließen. Der für die Bewegung der Drahtklemme 12 in Richtung des Bonddrahtes 34 verantwortliche Solenoid 41 erhält daraufhin den Befehl, die Drahtklemme 12 freizugeben, so daß sie durch die Abreißfeder 42 in die Abreißstellung (tear off-Position) ruckartig gezogen wird unter gleichzeitigem Abreißen des Drahtes 34 vom gebondeten Drahtabschnitt. Dabei bleibt der wedge 11 natürlich in Anlage an der zweiten Kontaktfläche unter Anpressung des gebondeten Drahtes an dieser. Anschließend wird der Bondkopf 10 wieder in die Startposition verfahren, die durch das Potentiometer 44 festgelegt ist. Damit ist ein Bond-Zyklus abgschlossen.

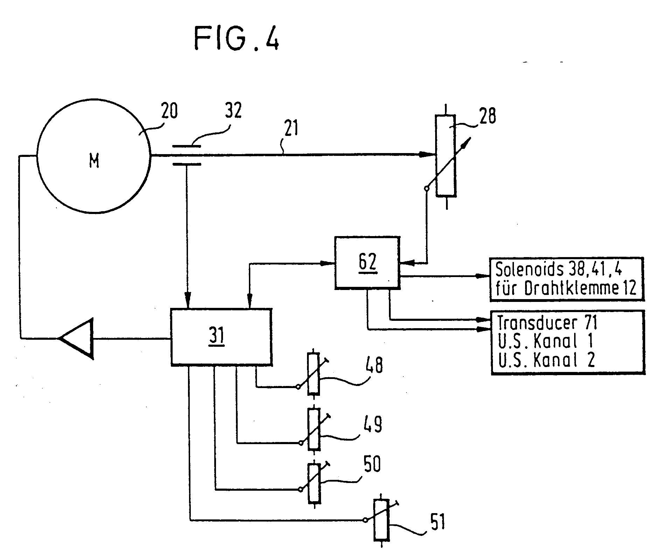

In Fig. 4 ist schematisch dargestellt, wie der dem Antrieb 20 zugeordnete Tachogenerator 32 der Geschwindigkeits-Wähleinrichtung 31 zugeordnet ist. Durch die Potentiometer 48-51 werden die Geschwindigkeiten des Bondkopfes für bestimmte Teilbewegungen festgelegt. Der Tachogenerator 32 stellt fest, ob die vorgegebenen Geschwindigkeiten eingehalten werden; falls nicht, erfolgt eine entsprechende Nachregulierung. Durch das feed-back-Potentiometer 28, das ebenfalls mit der Geschwindigkeits-Wähleinrichtung 31 gekoppelt ist, werden zum einen die Umschaltpunkte für die unterschiedlich gewählten Geschwindigkeiten festgelegt, zum anderen wird die Annäherung des Bondkopfes an eine vorgegebene Endposition angezeigt, so daß ein entsprechendes Bremssignal an den Motor 20 abgegeben werden kann. Das feed-back-Potentiometer 28 besitzt also eine Mehrfach-Funktion und ist für den Bewegungs- und Funktionsablauf der erfindungsgemäßen Vorrichtung von ganz wesentlicher Bedeutung.

Die Programmeinheit 62 ist darüberhinaus mit den Wegstrecken-Potentiometern 44 - 47 gekoppelt, so daß nach Erreichen vorbestimmter Bondkopf-Höhen und Bestätigung derselben durch das feed-back-Potentiometer 28 entsprechende Befehle an den transducer und/oder eine wedge-Heizeinrichtung sowie an die der Drahtklemme 12 zugeordneten Antriebselemente (Solenoid 38, 41, 44) abgeben zu können.

Den Fig. 5a bis 5c kann entnommen werden, daß beim Drücken des Startknopfes 53 unter Absenkung des Bondkopfes 10 auf die erste Bereitstellungshöhe 55 die Drahtklemme 12 den Befehl erhält, die sogenannte "tail length"-Position einzunehmen. Während der Verharrungszeit 63 wird die Drahtklemme 12 geöffnet und in Ausgangsposition bewegt. Beim erneuten Drücken des Startknopfes 53 unter Absenken des Bondkopfes 10 von der loop-Höhe 65 auf die zweite Bereitstellungshöhe 66 erhält die Drahtklemme 12 wieder den Befehl, zu schließen und sich in die Abreißposition zu bewegen. Nach Erreichen der zweiten Bereitstellungshöhe wird die Drahtklemme 12 wieder geöffnet. Die weiteren Befehle an die Drahtklemme 12 im Anschluß an den zweiten Bondvorgang sind anhand der Fig. 5c weiter oben beschrieben.

Der oben bereits mehrfach erwähnte, dem wedge bzw. Stempel 11 zugeordnete transducer ist in Fig. 1 mit der Bezugsziffer 71 gekennzeichnet.

Es sei nochmals darauf hingewiesen, daß der beschriebene Funktionsablauf beispielhaft ist und daß mit mehr oder weniger Rückmeldefunktionen gearbeitet werden kann, je nachdem, welche Anforderungen, insbesondere Qualitätsanforderungen, an das Bondverfahren gestellt werden. Es ist vor allem auch möglich, daß bei Feststellung einer Abweichung der Istgeschwindigkeiten von den Sollgeschwindigkeiten durch den Tachogenerator 32 oder Überschreiten einer vorgegebenen Grenzwert-Abweichung der Bondvorgang unterbrochen wird und durch Betätigung des reset-Schalters 52 erneut begonnen werden muß.

## Patentansprüche

1. Vorrichtung zum Drahtbonden mit einem ultraschallerregbaren und/oder Thermokompressions-Stempel (wedge 11) zum Anpressen des Drahtes (34) an eine Kontaktfläche, wobei der Stempel (11) Teil eines auf die Kontaktfläche zu- und von dieser wieder wegbewegbaren Bondkopfes (10) und die Kontaktfläche auf einer sich in Richtung etwa quer zur Bewegungsrichtung des Bondkopfes (10) unter Positionierung der Kontaktfläche gegenüber dem Stempel (11) bewegbaren Unterlage angeordnet ist, und mit einem Antrieb (20) für den Bondkopf (10), dem eine Wegstrecken- und Geschwindigkeits-Steuereinheit sowie eine Wegstrecken(28)- und Geschwindigkeits(32)-Rückmeldeeinheit zugeordnet sind, wobei der Bondkopf (10) nach folgendem Zyklus bewegbar ist:
a) Absenken des Bondkopfes (10) aus einer angehobenen Startposition (54) auf eine erste Bereitstellungsposition (55);
b) mit verringerter Geschwindigkeit weiteres Absenken des Bondkopfes (10) auf die erste Kontaktfläche (58) unter Anpressung des zu bondenden Drahtes (34) an dieser (erste "touch-down"-Stellung);
c) Abheben des Bondkopfes (10) von der ersten Kontaktfläche (58) unter Bewegung desselben in eine vorgegebene Loop-Position (65);
d) Absenken des Bondkopfes (10) auf eine zweite Bereitstellungsposition (66);
e) mit erneut verringerter Geschwindigkeit weiteres Absenken des Bondkopfes (10) auf die zweite Kontaktfläche unter Anpressung des zu bondenden Drahtes (34) an dieser (zweite "touch-down"-Stellung); und
f) Anheben des Bondkopfes (10) in die Startposition (54) nach vorheriger Abtrennung des gebondeten Drahtabschnittes,
**dadurch gekennzeichnet,** daß zum manuellen Drahtbonden die Wegstrecken- und Geschwindigkeits-Steuereinheit umfaßt:
a) einen manuell betätigbaren Schalter (Startknopf 53) zur Auslösung der Bondkopfbewegung aus der Startposition sowie der ersten (55) und zweiten (66) Bereitstellungsposition;
b) Wegstrecken-Potentiometer (44, 45, 46, 47) zur individuellen Vorgabe der Startposition (54), ersten Bereitstellungsposition (55), zweiten Bereitstellungsposition (66) und loop-Position bzw. -höhe (65),
c) Geschwindigkeits-Potentiometer (48, 49, 50, 51) zur individuellen Vorgabe der Geschwindigkeit des Bondkopfes (10) aus der Startposition (54) in die erste Bereitstellungsposition (55), aus der ersten Bereitstellungsposition (55) in die erste "touch-down"-Stellung, aus der ersten "touch-down"-Stellung in die loop-Position (65), aus der loop-Position (65) in die zweite Bereitstellungsposition (66), aus der zweiten Bereitstellungsposition (66) in die zweite "touch down"-Stellung, und aus der zweiten "touch-down"-Stellung zurück in die Startposition (54) umfaßt, wobei
d) die Geschwindigkeits-Potentiometer (48, 49, 50, 51) über eine Geschwindigkeits-Wähleinrichtung (31) mit dem Antrieb (20) gekoppelt sind,
e) einen Speicher (60) für die "touch down"-Höhe der ersten Kontaktfläche, von der aus die jeweils fest eingestellte loop-Höhe (65) bestimmbar ist, und
f) eine reset-Einrichtung (reset-Schalter 52), mittels der der Bondkopf (10) nach Meldung eines Wegstrecken-, Geschwindigkeits- und/oder Verharrungs-Fehlersignales in die Startposition (54) bringbar ist.

2. Vorrichtung nach Anspruch 1,
**dadurch gekennzeichnet,**
daß die Wegstrecken-Rückmeldeeinheit ein mit dem Abtrieb (Abtriebswelle 21) des Antriebs (20) vorzugsweise mechanisch gekoppeltes "feed back"-Potentiometer (28) umfaßt, dessen Ausgang mit einer Wegstrecken-Vergleichseinheit (30) gekoppelt ist, in der die durch die Wegstreckenpotentiometer (44, 45, 46, 47) vorgegebenen Sollwerte mit den durch das "feed back"-Potentiometer (28) festgestellten Bewegungs-Ist-Werten vergleichbar sind unter Auslösung eines Fehler (No)- oder Korrekt (Yes) -Signales.

3. Vorrichtung nach Anspruch 1 oder 2,
**dadurch gekennzeichnet,**
daß die den Geschwindigkeits-Potentiometern (48, 49, 50, 51) zugeordnete Geschwindigkeits-Wähleinrichtung (31) zum einen mit dem "feed back"-Potentiometer (28) und zum anderen mit einem als Geschwindigkeits-Rückmeldeeinheit (32) dienenden Tachogenerator gekoppelt ist, wobei durch das "feed back"-Potentiometer (28) die Geschwindigkeits-Umschaltpunkte definiert sind und durch den Tachogenerator (32) der Geschwindigkeits-Istwert der Bondkopfbewegung feststellbar ist, so daß bei Abweichung von einem vorgegebenen Geschwindigkeits-Sollwert eine Nachregulierung oder Unterbrechung des Bondvorganges möglich sind.

4. Vorrichtung nach einem oder mehreren der Ansprüche 1 bis 3,
**dadurch gekennzeichnet,**
daß der Stempel (wedge 11) im Bondkopf (10) etwa in Bewegungsrichtung desselben beweglich, insbesondere schwenkbar, gelagert ist, wobei er beim Aufsetzen (touch down) auf die Kontaktfläche entgegen der Wirkung eines elastischen Elements (z. B. Zugfeder 15) aus einer durch einen Anschlag (16) definierten Nullposition in eine "touch down"-Stellung bewegbar ist.

5. Vorrichtung nach Anspruch 4,
**dadurch gekennzeichnet,**
daß dem beweglich gelagerten Stempel (11) ein Sensor, vorzugsweise in Form einer Lichtschranke (Gabellichtschranke 18), zugeordnet ist, der die Relativbewegung des Stempels (11) beim "touch down" feststellt und ein Bewegungsstop-Signal für den Antrieb (20) des Bondkopfes (10) erzeugt.

6. Vorrichtung nach Anspruch 5,
**dadurch gekennzeichnet,**
daß durch den Sensor (Lichtschranke 18) eine vorbestimmte Relativwegstrecke (over drive) des Stempels (11) einstellbar ist.

7. Vorrichtung nach einem oder mehreren der Ansprüche 1 bis 6,
**dadurch gekennzeichnet,**
daß dem im Bondkopf (10) beweglich gelagerten Stempel (11) ein Schwingungsdämpfer, insbesondere in Form eines auf den Stempel (11) bzw. dessen Halterung (14) wirksamen Solenoids (33), zugeordnet ist, wobei der Schwingungsdämpfer (Solenoid 33) insbesondere bei Bewegung des Bondkopfes (10) von der Startposition (54) zur ersten Bereitstellungsposition (55) bzw. bei Bewegung des Bondkopfes (10) von der loop-Position (65) zur zweiten Bereitstellungsposition (66) wirksam ist.

8. Vorrichtung nach einem oder mehreren der Ansprüche 1 bis 7,
**dadurch gekennzeichnet,**
daß einer dem Stempel (11) zugeordneten Drahtklemme (12) bzw. deren Antriebselementen zum Öffnen bzw. Schließen (Solenoid 38) sowie zur relativen Bewegung gegenüber dem Stempel (11) in Richtung des sich durch die Drahtklemme (12) hindurch erstreckenden Bondrahtes (34)(Solenoid 41, 44) eine mit dem "feed back"-Potentiometer (28) gekoppelte Programm- bzw. Befehlseinheit (62) zugeordnet ist, durch die die erwähnten Antriebselemente (Solenoid bzw. Elektromagnete 38, 41, 44) steuerbar ist.

9. Vorrichtung nach einem oder mehreren der Ansprüche 1 bis 8,
**dadurch gekennzeichnet,**
daß der Bondkopf (10) mittels eines Kurbeltriebs oder eines am Bondkopf (10) einerseits und an einem durch den Antriebsmotor (20) drehangetriebenen Exzenter (22) andererseits gekoppelten Stößels (23) auf- und abbewegbar ist.

## Claims

1. Device for wire bonding having an ultrasonically excitable and/or thermo-compression die (wedge 11) for pressing the wire (34) onto a contact surface, the die (11) being part of a bonding head (10) which can be moved onto the contact surface and away again therefrom and the contact surface being arranged on a base which is movable approximately transversely to the direction of movement of the bonding head (10) with positioning of the contact surface with respect to the die (11), and having a drive (20) for the bonding head (10) to which a path length and velocity control unit and a path length (28) and velocity (32) checkback unit are allocated, the bonding head (10) being movable according to the following cycle:
a) lowering of the bonding head (10) from a raised starting position (54) to a first standby position (55);
b) further lowering of the bonding head (10) with a reduced velocity onto the first contact surface (58), pressing thereon the wire (34) to be bonded (first "touch-down" position);
c) raising the bonding head (10) from the first contact surface (58) with movement of the head into a predetermined loop position (65);
d) lowering of the bonding head (10) to a second standby position (66);
e) further lowering of the bonding head (10) with again reduced velocity onto the second contact surface with pressing thereon of the wire (34) to be bonded (second "touch-down" position); and
f) raising the bonding head (10) into the starting position (54) after prior separation of the bonded wire section,
characterised in that, for manual wire bonding, the path length and velocity control unit comprises;
a) a manually operable switch (starting button 53) for initiating the bonding head movement from the starting position and from the first (55) and second (66) standby position;
b) path length potentiometers (44, 45, 46, 47) for individual inputs of the starting position (54), first standby position (55), second standby position (66) and loop position and height (65),
c) velocity potentiometers (48, 49, 50, 51) for individual input of the velocity of the bonding head (10) from the starting position (54) into the first standby position (55), from the first standby position (55) into the first "touch-down" position, from the first "touch-down" position into the loop position (65), from the loop position (65) into the second standby position (66), from the second standby position (66) into the second "touch-down" position and from the second "touch-down" position back into the starting position (54),
d) the velocity potentiometers (48, 49, 50, 51) being coupled to the drive (20) via a velocity selection device (31),
e) a memory (60) for the "touch-down" height of the first contact surface, from which the particular loop height (65) with fixed setting can be determined, and
f) a reset device (reset switch 52) by means of which the bonding head (10) can be brought into the starting position (54) after report of a path length, velocity and/or pause error signal.

2. Device according to Claim 1, characterised in that the path length checkback unit comprises a "feed back" potentiometer (28) which is preferably mechanically coupled to the power take-off (driven shaft 21) of the drive (20) and whose output is coupled to a path length comparison unit (30) in which the setpoint values defined by the path length potentiometers (44, 45, 46, 47) can be compared with the actual values for movement registered by the "feed back" potentiometer (28) to trigger an error (no) or correct (yes) signal.

3. Device according to Claim 1 or 2, characterised in that the velocity selection device (31) allocated to the velocity potentiometers (48, 49, 50, 51) is coupled on the one hand to the "feed back" potentiometer (28) and on the other hand to a tacho-generator which serves as a velocity checkback unit (32), the velocity changeover points being defined by the "feed back" potentiometer (28) and the actual value for the velocity of the bonding head movement being ascertainable from the tacho-generator (32) so that, upon deviation from a defined velocity setpoint value, a correction or interruption of the bonding operation is possible.

4. Device according to one or more of Claims 1 to 3, characterised in that the die (wedge 11) is mounted in the bonding head (10) so as to be movable, in particular pivotable, in the direction of movement thereof, the die being movable, upon touch-down on the contact surface, from a zero position defined by a stop (16) into a "touch-down" position against the action of an elastic element (for example tensioning spring 15).

5. Device according to Claim 4, characterised in that a sensor, preferably in the form of a light barrier (forked light barrier 18), is allocated to the movably mounted die (11), which sensor determines the relative movement of the die (11) on "touch-down" and generates a movement stop signal for the drive (20) of the bonding head (10).

6. Device according to Claim 5, characterised in that a predetermined relative path length (overdrive) of the die (11) can be adjusted by means of the sensor (light barrier 18).

7. Device according to one or more of Claims 1 to 6, characterised in that a vibration damper, in particular in the form of a solenoid (33) which acts on the die (11) or its mount (14), is allocated to the die (11) which is movably mounted in the bonding head (10), the vibration damper (solenoid 33) acting in particular during movement of the bonding head (10) from the starting position (54) to the first standby position (55) and during movement of the bonding head (10) from the loop position (65) to the second standby position (66).

8. Device according to one or more of Claims 1 to 7, characterised in that a programming or command unit (62) which is coupled to the "feed back" potentiometer (28) is allocated to a wire grip (12), allocated to the die (11), and to the drive elements of said wire grip for opening and closing (solenoid 38) and for the relative movement with respect to the die (11) towards the bonding wire (34) which extends through the wire grip (12) (solenoid 41, 44), by means of which programming or command unit (62) the said drive elements (solenoid or electromagnets 38, 41, 44) can be controlled.

9. Device according to one or more of Claims 1 to 8, characterised in that the bonding head (10) can be moved up and down by means of a crank mechanism or a plunger (23) coupled to the bonding head (10) on the one hand and to an eccentric (22), on the other hand, which eccentric is rotationally driven by the drive motor (20).

## Revendications

1. Dispositif pour la connexion de fils comprenant un poinçon (coin 11) excitable par ultrasons et/ou à thermocompression pour le pressage du fil (34) sur une surface de contact, le poinçon (11) faisant partie d'une tête de connexion (10) pouvant être déplacée vers la surface de contact et de nouveau éloignée de celle-ci et la surface de contact étant disposée sur un support mobile dans une direction à peu près transversale à la direction de déplacement de la tête de connexion (10) de façon à positionner la surface de contact par rapport au poinçon (11), et comprenant un organe d'entraînement (20) pour la tête de connexion (10), auquel sont associées des unités de commande de trajet et de vitesse ainsi que des unités de retour de trajet (28) et de vitesse (32), la tête de connexion (10) étant déplaçable selon le cycle suivant :
(a) abaissement de la tête de connexion (10) d'une position de départ relevée (58) à une première position d'attente (55);
(b) nouvel abaissement de la tête de connexion (10) à une vitesse réduite sur une première surface de contact (58) avec pressage du fil (34) à connecter sur celle-ci (première position de "touch-down");
(c) relèvement de la tête de connexion (10) depuis la première surface de contact (58) avec déplacement de celle-là dans une position de demi-tour prédéterminée (65);
(d) abaissement de la tête de connexion (10) à une seconde position d'attente (66);
(e) nouvel abaissement de la tête de connexion (10) avec une vitesse de nouveau réduite sur une seconde surface de contact avec pressage du fil (34) à connecter sur celle-ci (seconde position de "touch-down"); et
(f) relèvement de la tête de connexion (10) dans la position de départ (54) après séparation préalable de la section de fil connectée,
caractérisé en ce que, pour la connexion manuelle de fils, l'unité de commande de trajet et de vitesse comporte :
(a) un commutateur à actionnement manuel (bouton de démarrage 53) pour le déclenchement du déplacement de la tête de connexion à partir de la position de départ ainsi que des première (55) et seconde (66) positions d'attente;
(b) des potentiomètres de trajet (44,45,46,47) pour la fixation individuelle de la position de départ (54), de la première position d'attente (55), de la seconde position d'attente (66) et de la position ou hauteur de demi-tour (65),
(c) des potentiomètres de vitesse (48,49,50,51) pour la fixation individuelle de la vitesse de la tête de connexion (10) de la position de départ (54) à la première position d'attente (55), de la première position d'attente (55) à la première position de "touch-down", de la première position de "touch-down" à la position de demi-tour (65), de la position de demi-tour (65) à la seconde position d'attente (66), de la seconde position d'attente (66) à la seconde position de "touch-down", et de la seconde position de "touch-down" en retour à la position de départ (54),
(d) les potentiomètres de vitesse (48,49,50,51) étant couplés à l'organe d'entraînement (20) par l'intermédiaire d'un agencement de choix de vitesse (31),
(e) une mémoire (60) pour la hauteur de "touch-down" de la première surface de contact, à partir de laquelle peut être déterminée la hauteur de demi-tour réglée à chaque fois de façon fixe, et
(f) un agencement de remise à zéro (commutateur de remise à zéro 52), au moyen de laquelle la tête de connexion (10) peut être amenée dans la position de départ (54) après émission d'un signal d'erreur de trajet, de vitesse et/ou de persistance.

2. Dispositif selon la revendication 1, caractérisé en ce que l'unité de retour de trajet comporte un potentiomètre de "feed-back" (28) couplé de préférence mécaniquement à la sortie (arbre de sortie 21) de l'organe d'entraînement (20), dont la sortie est couplée à une unité de comparaison de trajets (30) dans laquelle la valeur de consigne fixée par les potentiomètres de trajet (44,45,46,47) peut être comparée aux valeurs réelles déterminées par le potentiomètre de "feed-back" (28) avec émission d'un signal "Erreur" (Non) ou "Correct" (Oui).

3. Dispositif selon l'une des revendications 1 et 2, caractérisé en ce que l'agencement de choix de vitesse (31) associé aux potentiomètres de vitesse (48,49,50,51) est couplé d'une part au potentiomètre de "feed-back" (28) et d'autre part à une génératrice tachymétrique servant d'unité de retour de vitesse (32), les points d'inversion de vitesse étant définis par le potentiomètre de "feed-back" (28) et la valeur réelle de vitesse du mouvement de la tête de connexion pouvant être déterminée par la génératrice tachymétrique (32), de sorte qu'en cas d'écart par rapport à une valeur de consigne de vitesse prédéfinie, un réglage correctif ou une interruption du processus de connexion est possible.

4. Dispositif selon une ou plusieurs des revendications 1 à 3, caractérisé en ce que le poinçon (coin 11) est monté dans la tête de connexion (10) de façon quelque peu mobile dans la direction de déplacement de celle-ci, et est ainsi déplaçable contre l'action d'un élément élastique (p.e. ressort de traction 15), lors de l'application (touch-down) sur la surface de contact, d'une position zéro définie par une butée (16) à une position de "touch-down".

5. Dispositif selon la revendication 4, caractérisé en ce qu'au poinçon (11) monté mobile est associé un détecteur, de préférence sous forme d'une barrière lumineuse (barrière lumineuse à fourche 18) qui détermine le mouvement relatif du poinçon (11) lors du "touch-down" et produit un signal d'arrêt de mouvement pour l'organe d'entraînement (20) de la tête de connexion (10).

6. Dispositif selon la revendication 5, caractérisé en ce qu'un trajet relatif (dépassement) prédéterminé du poinçon (11) peut être réglé au moyen du détecteur (barrière lumineuse 18).

7. Dispositif selon une ou plusieurs des revendications 1 à 6, caractérisé en ce qu'au poinçon (11) monté mobile dans la tête de connexion (10) est associé un amortisseur d'oscillation, en particulier sous la forme d'un solénoïde (33) agissant sur le poinçon (11) ou sur sa monture (14), l'amortisseur d'oscillation (solénoïde 33) agissant en particulier lors du déplacement de la tête de connexion (10) de la position de départ (54) à la première position d'attente (55) ou lors du déplacement de la tête de connexion (10) de la position de demi-tour (65) à la seconde position d'attente (66).

8. Dispositif selon une ou plusieurs des revendications 1 à 7, caractérisé en ce qu'à une pince à fil (12) associée au poinçon (11) et/ou à ses éléments d'entraînement pour l'ouverture et la fermeture (solénoïde 38), ainsi que pour le mouvement relatif par rapport au poinçon (11) dans la direction du fil à connecter (34) s'étendant à travers la pince à fil (12)(solénoïde 41,44), est associée une unité de programme ou d'instructions (62) couplée au potentiomètre de "feed-back" (28), par laquelle lesdits éléments d'entraînement (solénoïde et/ou électro-aimant 38, 41, 44) peuvent être commandés.

9. Dispositif selon une ou plusieurs des revendications 1 à 8, caractérisé en ce que la tête de connexion (10) est déplaçable vers le haut et vers le bas au moyen d'un mécanisme à manivelle ou d'un coulisseau (23) couplé à la tête de connexion (10) d'une part et à un excentrique (22) entraîné en rotation par le moteur d'entraînement (20) d'autre part.
